# FASCICULE DE BREVET EUROPEEN

(11) **EP 1 458 902 B1**
(45) Date de publication et mention de la délivrance du brevet: **27.09.2006**
(21) Numéro de dépôt: 02799114.0
(22) Date de dépôt: 24.12.2002
(51) Int. Cl.: C23C 16/04, C04B 41/45, C23C 16/455

(54) **PROCEDE ET INSTALLATION DE DENSIFICATION DE SUBSTRATS POREUX PAR INFILTRATION CHIMIQUE EN PHASE GAZEUSE**
VERFAHREN UND VORRICHTUNG ZUR VERDICHTUNG PORÖSER SUBSTRATE MITTELS CHEMISCHER DAMPFINFILTRATION
METHOD AND INSTALLATION FOR DENSIFYING POROUS SUBSTRATE BY GAS-PHASE CHEMICAL INFILTRATION

(30) Priorité: 26.12.2001 US 34848
(43) Date de publication de la demande: 22.09.2004
(73) Titulaire: MESSIER-BUGATTI, 78140 Velizy Villacoublay (FR)
(72) Inventeur: SION, Eric, F-67190 Mutzig (FR); BAUDRY, Yvan, F-33700 Merignac (FR); DELPERIER, Bernard, F-33127 Martignas sur Jalle (FR)
(74) Mandataire: Joly, Jean-Jacques
(86) Numéro de dépôt international: PCT/FR2002/004554
(87) Numéro de publication internationale: WO 2003/056059

(56) Documents cités:
- EP-A- 0 995 814
- WO-A-96/33295
- WO-A-98/17599
- US-A- 5 362 228
- US-A- 5 480 678
- US-B1- 6 248 434

## Description

### Arrière-clan de l'invention

L'invention concerne la densification de substrats poreux par infiltration chimique en phase gazeuse.

Le domaine d'application de l'invention est celui de la réalisation de pièces en matériau composite thermostructural, c'est-à-dire en matériau composite ayant à la fois des propriétés mécaniques qui le rendent apte à constituer des pièces structurelles et la capacité de conserver ces propriétés jusqu'à des températures élevées. Des exemples typiques de matériaux composites thermostructuraux sont les composites carbone/carbone (C/C) ayant une texture de renfort en fibres de carbone densifiée par une matrice de carbone pyrolytique et les composites à matrice céramique (CMC) ayant une texture de renfort en fibres réfractaires (carbone ou céramique) densifiée par une matrice céramique.

Un processus bien connu de densification de substrats poreux pour réaliser des pièces en composite C/C ou en CMC est l'infiltration chimique en phase gazeuse. Les substrats à densifier sont placés dans une zone de chargement d'un four où ils sont chauffés. Un gaz réactif contenant un ou plusieurs précurseurs gazeux du matériau constitutif de la matrice est introduit dans le four. La température et la pression dans le four sont réglées pour permettre au gaz réactif de diffuser au sein de la porosité des substrats et y former un dépôt du matériau constitutif de la matrice par décomposition d'un ou plusieurs constituants du gaz réactif ou réaction entre plusieurs constituants, ces constituants formant le précurseur de la matrice. Le processus est réalisé sous pression réduite, afin de favoriser la diffusion des gaz réactifs dans les substrats. La température de transformation du ou des précurseurs pour former le matériau de la matrice, tel que carbone pyrolytique ou céramique, est dans la plupart des cas supérieure à 900° C, typiquement voisine de 1000° C.

Afin de réaliser une densification la plus homogène possible des substrats dans toute la zone de chargement du four, que ce soit en terme d'accroissement de densité ou en terme de microstructure du matériau de matrice formé, il est nécessaire que la température dans toute la zone de chargement soit sensiblement uniforme.

Aussi, les fours comportent habituellement une zone de chauffage de gaz réactif située entre l'entrée du gaz réactif dans le four et la zone de chargement. Typiquement, la zone de chauffage comprend une pluralité de plateaux perforés parcourus par le gaz réactif.

Les plateaux de chauffage du gaz, de même que les substrats sont chauffés du fait de leur présence dans le four. Le chauffage de ce dernier est généralement assuré au moyen d'un induit (ou suscepteur), par exemple en graphite, qui définit la paroi latérale du four et est couplé à un inducteur entourant le four.

Il a été observé par la déposante que la présence d'une zone de chauffage du gaz réactif n'apporte pas toujours le résultat souhaité. Un exemple significatif est celui de la densification de substrats constitués par des préformes annulaires en fibres de carbone, ou des ébauches annulaires prédensifiées, pour la réalisation de disques de frein en composite C/C. Les substrats sont disposés en une ou plusieurs piles verticales dans la zone de chargement, au-dessus de la zone de chauffage du gaz réactif située à la partie inférieure du four. En dépit du chauffage du gaz réactif, un gradient de température est observé entre le bas de la zone de chargement et le reste de celle-ci, la température au niveau des substrats situés en bas de pile pouvant être de plusieurs dizaines de °C inférieure à celle régnant au niveau du reste de la pile. Il en résulte un gradient de densification important entre les substrats selon leur position dans la pile.

Afin de résoudre ce problème, il pourrait être envisagé d'accroître l'efficacité du chauffage du gaz réactif par agrandissement de la zone de chauffage. Toutefois, à volume total de four égal, cela conduirait à réduire le volume utile dans la zone de chargement. Or, les processus d'infiltration chimique en phase gazeuse demandent des investissements coûteux à l'échelle industrielle, et sont très longs à réaliser. Il est donc hautement souhaitable que les fours aient une productivité élevée, que ce soient des fours en service ou de nouveaux fours à réaliser, donc un rapport aussi élevé que possible entre volume utile dédié au chargement des substrats et volume dédié au chauffage du gaz réactif.

### Objet et résumé de l'invention

L'invention a pour but de proposer un procédé de densification par infiltration chimique en phase gazeuse qui permet d'avoir un gradient de température très réduit dans toute la zone de chargement sans requérir un volume important de la zone de chauffage du gaz réactif, donc sans affecter, et voire même en améliorant la productivité des fours.

Ce but est atteint avec un procédé du type comportant :
- le chargement de substrats à densifier dans une zone de chargement du four,
- le chauffage des substrats dans le four afin de les porter à une température à laquelle le matériau de matrice souhaité est formé à partir du ou des précurseurs gazeux contenus dans le gaz réactif,
- l'admission du gaz réactif à une extrémité du four, et
- le chauffage du gaz réactif, après entrée dans le four, par passage dans une zone de chauffage de gaz située en amont de la zone de chargement, dans le sens d'écoulement du gaz réactif dans le four,
procédé dans lequel, conformément à l'invention,
- le gaz réactif est préchauffé avant entrée dans le four pour être amené, à son entrée dans le four, à une température intermédiaire entre la température ambiante et la température de chauffage des substrats.

Le préchauffage du gaz réactif à l'extérieur du four permet à la zone de chauffage située dans le four d'être plus efficace pour amener le gaz réactif à la température voulue dès son entrée dans la zone de chargement des substrats.

Lorsque la température à laquelle l'infiltration est réalisée est supérieure à 900°C, le gaz réactif est préchauffé, avant entrée dans le four pour être amené, à son entrée dans le four, à une température de préférence au moins égale à 200°C. Toutefois, il est préférable que la température de préchauffage du gaz n'excède pas 800°C, voire même 600°C pour éviter un risque de dépôts parasites par transformation du ou des précurseurs avant entrée dans le four, et pour permettre l'utilisation de matériaux relativement courants pour des canalisations d'alimentation du four en gaz réactif préchauffé et des composants tels que vanne(s) et joint(s) montés sur ces canalisations.

Le préchauffage peut être réalisé à une pression de gaz sensiblement égale à celle régnant dans le four ou à une pression supérieure. Dans ce dernier cas, le gaz réactif préchauffé est détendu avant entrée dans le four.

L'invention vise aussi à fournir une installation permettant la mise en oeuvre du procédé.

Ce but est atteint grâce à une installation du type comprenant : un four, une zone de chargement de substrats dans le four, des moyens de chauffage de substrats dans la zone de chargement, au moins une entrée de gaz réactif dans le four, et une zone de chauffage de gaz située dans le four entre l'entrée du gaz réactif et la zone de chargement,
installation dans laquelle, conformément à l'invention, il est en outre prévu au moins un dispositif de préchauffage de gaz situé à l'extérieur du four et relié à au moins une entrée de gaz réactif dans le four, de manière à préchauffer le gaz réactif avant son entrée dans le four.

Selon un mode de réalisation de l'invention, le dispositif de préchauffage comporte un tube à passage de courant inséré sur un conduit d'amenée du gaz réactif à l'entrée du gaz réactif dans le four.

Selon d'autres modes de réalisation de l'invention, le dispositif de préchauffage comporte une chaudière à gaz ou un four électrique parcouru par au moins un conduit ou un faisceau de tubes pour la circulation du gaz réactif à préchauffer.

### Brève description des dessins

D'autres particularités et avantages du procédé et de l'installation conformes à l'invention ressortiront à la lecture de la description faite ci-après, à titre indicatif mais non limitatif, en référence aux dessins annexés sur lesquels :
- la figure 1 est une vue très schématique en coupe d'un premier mode de réalisation d'une installation de densification conforme à l'invention ;
- la figure 2 montre des courbes illustrant l'évolution de la température de gaz réactif depuis avant son entrée dans le four jusqu'après son entrée dans la zone de chargement de substrats, avec préchauffage du gaz réactif et sans préchauffage du gaz réactif ;
- la figure 3 est une vue très schématique en coupe d'un deuxième mode de réalisation d'une installation de densification conforme à l'invention ;
- la figure 4 illustre un autre mode de chargement de substrats dans une installation de densification ;
- la figure 5 illustre schématiquement encore un mode de chargement de substrats dans un four en plusieurs piles annulaires ;
- la figure 6 est une vue très schématique en coupe selon le plan VI-VI de la figure 5 ; et
- la figure 7 est une vue partielle d'une installation de densification montrant une variante de réalisation de l'alimentation du four en gaz réactif, avec un chargement du four formé de plusieurs piles de substrats.

### Description détaillée de modes de réalisation

Des modes de réalisation du procédé et de l'installation conformes à l'invention seront décrits ci-après dans le cadre de l'application à la densification de substrats poreux annulaires constitués par des préformes en fibres de carbone ou des ébauches prédensifiées destinées à la réalisation de disques de frein en matériau composite C/C. De tels disques sont couramment utilisés pour des roues d'avions et pour des automobiles de compétition.

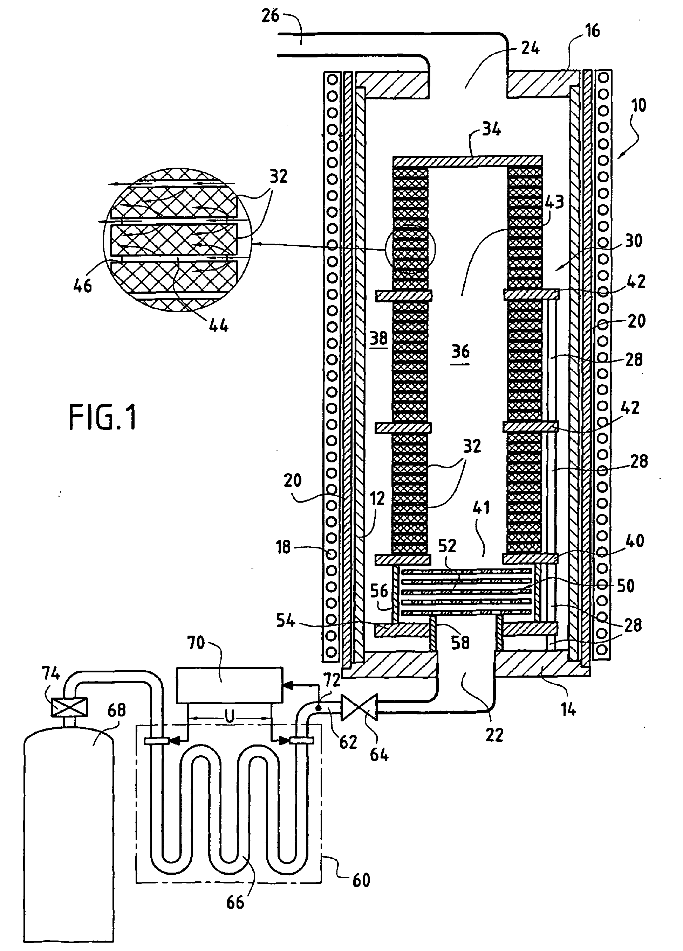

La figure 1 montre schématiquement un four 10 délimité par une paroi latérale cylindrique 12, une paroi de fond 14 et une paroi supérieure 16. La paroi 12 constitue un induit, ou suscepteur, par exemple en graphite, qui est couplé avec un inducteur 18 situé à l'extérieur du four, avec interposition d'un isolant 20. Le chauffage du four est assuré par l'induit 12 par alimentation électrique de l'inducteur 18.

Le gaz réactif est introduit dans le four à travers un passage 22 formé dans la paroi de fond 14 et le gaz effluent est extrait par un passage 24 formé dans la paroi supérieure 16, le passage 24 étant relié par une conduite 26 à des moyens d'aspiration, tels qu'une pompe à vide (non représentée).

Les substrats à densifier 32 sont disposés de manière à former une pile verticale annulaire fermée à sa partie supérieure par un couvercle 34. Ainsi, les substrats empilés partagent le volume interne de la zone de chargement 30 entre un volume 36 interne à la pile, formé par les passages centraux alignés des substrats, et un volume 38 externe à la pile.

La pile de substrats repose sur un plateau support inférieur 40 et peut être divisée en plusieurs sections superposées séparées par un ou plusieurs plateaux intermédiaires 42, les plateaux 40, 42 ayant des passages centraux 41, 43 alignés avec ceux des substrats 32. Bien qu'une seule pile soit représentée sur la figure 1, plusieurs piles pourront être disposées côte à côte dans le four 10 comme décrit plus loin.

Comme le montre le détail de la figure 1, chaque substrat 32 est séparé d'un substrat adjacent ou, le cas échéant, d'un plateau 40, 42 ou du couvercle 34 par des cales d'espacement 44 qui définissent des intervalles 46. Les cales 44, ou au moins une partie d'entre elles, sont aménagées pour ménager des passages pour le gaz entre les volumes 36 et 38 à travers des intervalles 46. Ces passages peuvent être réalisés de manière à équilibrer sensiblement la pression entre les volumes 36 et 38, comme décrit dans le brevet US 5 904 957, ou de manière à constituer de simples passages de fuite maintenant un gradient de pression entre les volumes 36 et 38, comme décrit dans la demande de brevet déposée sous le numéro FR 01 03004.

Une zone de chauffage de gaz 50 s'étend entre le fond 14 du four et le plateau support inférieur 40. De façon bien connue, la zone de chauffage 50 comprend plusieurs plateaux perforés 52, par exemple en graphite, disposés les uns au-dessus des autres, et espacés les uns des autres. Les plateaux 52 peuvent être logés dans un boîtier ayant un fond 54 et une paroi latérale 56, et délimitant la zone de chauffage. Une conduite 58 relie l'entrée de gaz réactif 22 à la zone de chauffage 30, à travers le fond 54.

Des piètements et colonnettes 28 supportent le boîtier de chauffage et les plateaux 40, 42. L'ensemble de ces éléments est réalisé par exemple en graphite.

Le gaz réactif admis dans le four à travers l'entrée 22 traverse la zone de chauffage 50 et parvient dans le volume 36 à travers l'orifice central 41 du plateau 40. Le gaz réactif circule du volume 36 vers le volume 38 en passant à travers la porosité des substrats 32 et à travers les passages dans les intervalles 46. Le gaz effluent est extrait du volume 38 à travers la sortie 24.

Selon une variante de réalisation, le volume 36 peut être fermé à sa partie inférieure et mis en communication avec la sortie 24 à sa partie supérieure. Le gaz réactif provenant de la zone de chauffage 30 est alors admis dans le volume 38 de la zone de chargement et la circulation du gaz dans cette zone se fait du volume 38 vers le volume 36, le volume 38 étant obturé à sa partie supérieure.

Selon encore une autre variante, l'entrée du gaz réactif peut être réalisée à travers la paroi supérieure 16 du four, la zone de chauffage étant alors située à la partie supérieure du four. Celui des deux volumes 36, 38 qui est en communication avec la zone de chauffage est obturé à sa partie inférieure tandis que l'autre de ces deux volumes communique avec une sortie de gaz formée dans la paroi inférieure du four.

Pour la formation d'une matrice en carbone pyrolytique, le gaz réactif contient un ou plusieurs précurseurs du carbone tels que des hydrocarbures. Des précurseurs couramment utilisés sont le méthane, le propane ou un mélange des deux. L'infiltration chimique en phase gazeuse est réalisée à une température généralement supérieure à 900°C, par exemple comprise entre 950°C et 1100°C, et sous une pression réduite, par exemple inférieure à 0,1 kPa.

Conformément à l'invention, le gaz réactif est préchauffé avant d'être admis dans le four, par passage dans un dispositif de préchauffage 60 relié par une conduite d'alimentation 62 à l'entrée 22 du four. La conduite 62 est de préférence isolée thermiquement. Une vanne d'isolement 64 est montée sur la conduite 62 immédiatement en amont de l'entrée 22 du four afin, le cas échéant, de pouvoir isoler le four du circuit d'alimentation en gaz réactif.

Dans le mode de réalisation de la figure 1, le dispositif de préchauffage comprend un tube à passage de courant 66 qui est parcouru par le gaz réactif venant d'une source 68 et est relié à la conduite 62.

Les tubes à passage de courant sont des dispositifs connus pour le chauffage de fluides circulants. La chaleur est produite par effet Joule en faisant circuler un courant électrique le long d'une portion du tube. Le tube constitue à la fois une résistance électrique, un conduit pour le fluide et une surface d'échange thermique.

Le courant électrique est produit par un circuit d'alimentation électrique 70 délivrant une tension U et connecté aux extrémités de la portion de tube. Le circuit 70 reçoit une information fournie par un capteur 72, par exemple un thermocouple, disposé à la sortie du dispositif de préchauffage. La température de préchauffage est régulée à une valeur prédéterminée par ajustement automatique de la tension U en fonction de la température mesurée par le capteur 72.

Le chauffage du gaz réactif peut être réalisé sous la pression réduite régnant dans le four, un détendeur 74 étant disposé en sortie de la source de gaz 68.

En variante, le chauffage du gaz réactif peut être réalisé sous une pression supérieure à celle régnant dans le four, à savoir une pression intermédiaire entre celle de la source 68 et celle régnant dans le four. Dans ce cas, le gaz réactif préchauffé est détendu avant entrée dans le four, par exemple par passage à travers un orifice calibré monté dans la conduite d'alimentation 62.

Le préchauffage du gaz réactif a pour objet de permettre que le gaz, après chauffage complémentaire par passage dans la zone de chauffage 50, pénètre dans la zone de chargement à une température égale ou voisine de celle nécessaire pour éviter un gradient de température notable entre le bas de la zone de chargement et le reste de celle-ci.

Afin d'être efficace, le préchauffage du gaz réactif doit de préférence être réalisé pour amener le gaz à son entrée dans le four à une température de 200°C au moins.

La température de préchauffage, c'est-à-dire la température en sortie du dispositif de préchauffage, doit toutefois être limitée pour éviter le risque de formation de dépôts parasites (suies) dans la conduite d'alimentation 62, et en raison de contraintes d'ordre technologique.

Ainsi, on choisira une température de préchauffage au plus égale à 800°C pour éviter les dépôts parasites, et de préférence au plus égale à 600°C pour pouvoir utiliser des matériaux d'un coût abordable pour la conduite 62 (par exemple un acier) ainsi que pour la vanne d'isolement 64 et d'autres composants éventuels exposés au gaz préchauffé, tels que des joints d'étanchéité.

Selon la longueur de la conduite 62 et son calorifugeage, une diminution plus ou moins importante de la température du gaz préchauffé peut se produire après sortie du dispositif de préchauffage et avant son entrée dans le four. Ainsi, avec un préchauffage à 600°C, la température du gaz peut perdre quelques degrés à quelques dizaines de degrés avant de remonter à son entrée dans le four, voire même un peu avant son entrée, en raison de l'influence de l'atmosphère du four.

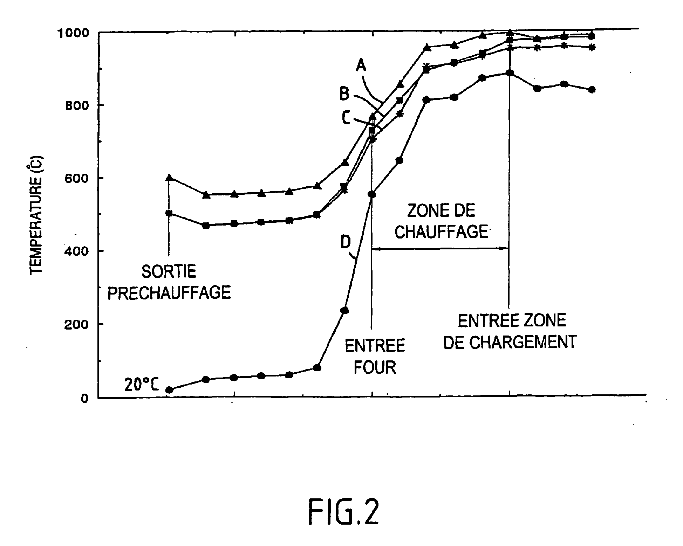

Un essai a été effectué en alimentant un four semblable à celui de la figure 1 avec un gaz réactif préchauffé à 600°C. La température du gaz a été mesurée à la sortie du dispositif de préchauffage, le long de la conduite d'alimentation, à l'entrée dans le four et à la sortie de la zone de chauffage 50 située dans le four. La courbe A de la figure 2 illustre la variation de température observée.

Deux autres essais semblables ont été effectués à une température de préchauffage de 500°C, respectivement avec le même débit de gaz réactif et avec un débit augmenté d'environ 42 %. Les courbes B et C de la figure 2 illustrent les variations de température mesurées.

A titre de comparaison, un essai a été effectué sans préchauffage, le gaz réactif étant admis dans la conduite 62 à une température de 20°C avec le même débit que dans le cas du préchauffage à 600°C. La courbe D de la figure 2 illustre la variation de température du gaz réactif mesurée jusqu'à entrée dans la zone de chargement du four.

Pour un même débit de gaz réactif, et avec une même zone de chauffage, le préchauffage du gaz à 600°C et 500°C (courbes A et B) permet d'amener celui-ci à une température d'environ 993°C et 975°C à son entrée dans la zone de chargement alors que, sans préchauffage (courbe D), cette température est nettement inférieure à 850°C.

Ainsi, un gradient de température susceptible d'entraîner un gradient notable de densification entre les substrats situés au bas de la pile et les autres est évité grâce au préchauffage du gaz.

La déposante estime qu'une augmentation du rendement de la zone de chauffage 50 permettant, sans préchauffage du gaz, d'atteindre un résultat semblable à celui obtenu avec préchauffage du gaz, nécessiterait d'empiéter sur au moins 5 % du volume de la zone de chargement. Le préchauffage du gaz réactif à l'extérieur du four permet donc d'améliorer de façon sensible la productivité de celui-ci.

En outre, le préchauffage à 500°C conserve son efficacité avec un débit sensiblement augmenté puisque la température à l'entrée de la zone de chargement est d'environ 950°C (courbe C). Le préchauffage autorise donc une augmentation du débit du gaz réactif, ce qui est favorable à une diminution de la durée totale du processus de densification.

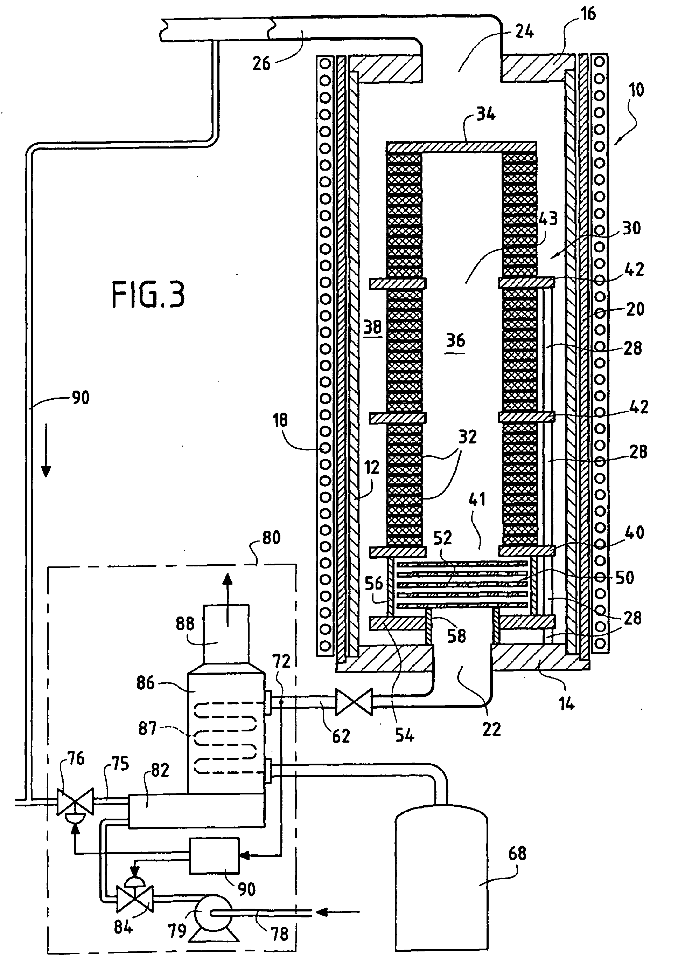

La figure 3 montre une variante de réalisation de l'installation de densification qui se distingue de celle de la figure 1 en ce que le dispositif de préchauffage 80 est formé non pas par un tube à passage de courant, mais par une chaudière à gaz.

La chaudière 80 comprend un brûleur 82 alimenté en gaz carburant, par exemple en hydrocarbure gazeux tel que gaz naturel, via une conduite 75 sur laquelle est montée une vanne de régulation 76. Le brûleur 82 est alimenté en air de dilution via une conduite 78 sur laquelle sont montés un compresseur 79 et une vanne de régulation 84. Les gaz de combustion produits traversent un échangeur de chaleur 86 avant d'être évacués par une cheminée 88. Le gaz réactif provenant de la source 68 parcourt l'échangeur de chaleur 86 à travers un conduit 87 avant d'être admis dans le four via la conduite d'alimentation 62.

Les vannes de régulation 76 et 84 sont commandées par un circuit de régulation 90 en fonction d'un signal fourni par un capteur de température 72 en sortie de la chaudière 80 afin de régler la température de préchauffage du gaz réactif à la valeur désirée.

Une fraction du gaz effluent peut être prélevée sur la conduite 26 afin d'être mélangée au gaz carburant alimentant le brûleur de la chaudière.

Bien entendu, d'autres types de dispositifs de chauffage de fluide pourront être utilisés pour le préchauffage du gaz réactif.

Ainsi, le gaz réactif peut être préchauffé par circulation dans un tube ou un faisceau de tubes dans un four chauffé par résistances électriques, la température du gaz réactif en sortie du dispositif de chauffage étant régulée par contrôle de l'alimentation des résistances électriques.

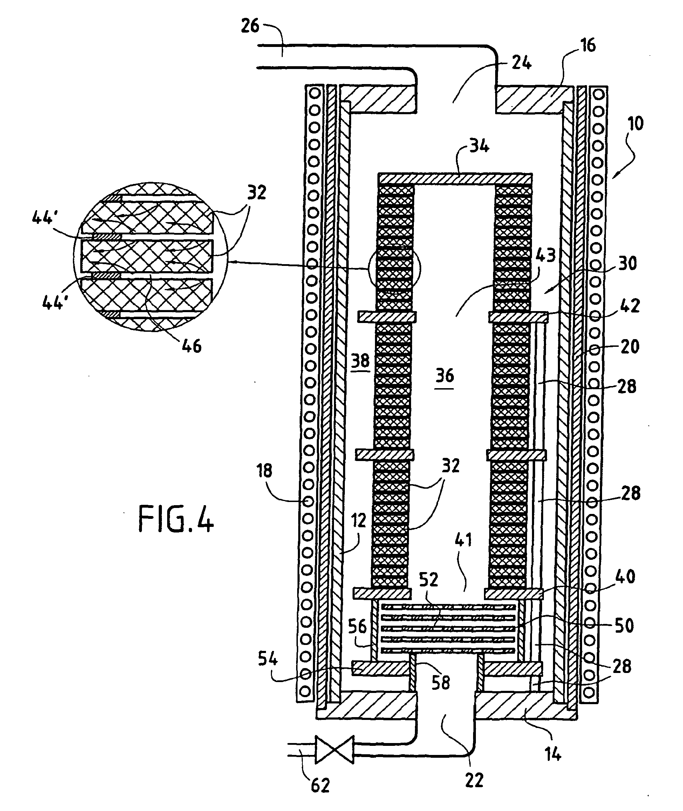

La figure 4 illustre une variante de réalisation du chargement de substrats 32. Comme le montre le détail de la figure 4, les intervalles 46 entre substrats voisins ou entre substrat et plateau 40, 42 ou couvercle 34 sont munis de cales d'espacement annulaires 44' qui obturent de façon étanche les intervalles 46. De la sorte, le passage de gaz réactif du volume 36 au volume 38 se fait uniquement à travers la porosité des substrats, ce qui induit un gradient de pression assez important entre ces deux volumes.

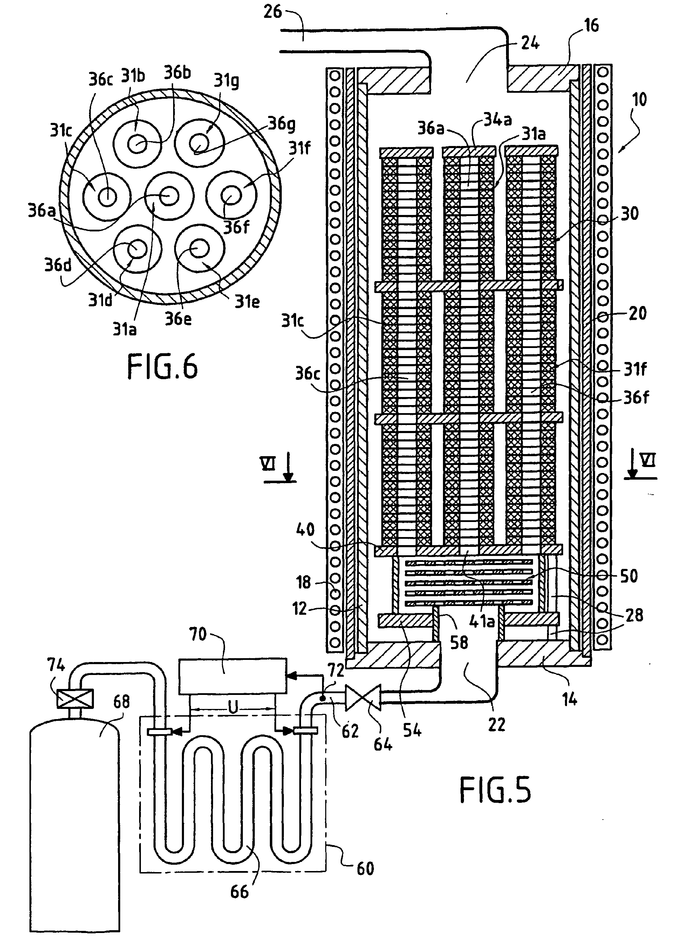

Les figures 5 et 6 illustrent une variante de réalisation du chargement des substrats qui se distingue du chargement de la figure 1 en ce que les substrats 32 sont disposés en une pluralité de piles annulaires 31a, 31b, 31c, 31d, 31e, 31f, 31g qui reposent sur le plateau support 40. Celui-ci comprend une pluralité de passages tels que 41a alignés avec les volumes internes 36a à 36g des piles et chaque pile est obturée à sa partie supérieure par un couvercle tel que 34a. La circulation du gaz réactif se fait à travers la zone de chauffage 50 puis dans les volumes internes des piles d'où le gaz passe dans le volume 38 externe aux piles à l'intérieur de la zone de chargement 30. Bien que 7 piles soient représentées sur la figure 6, le nombre de piles pourra bien entendu être différent, en particulier supérieur à 7.

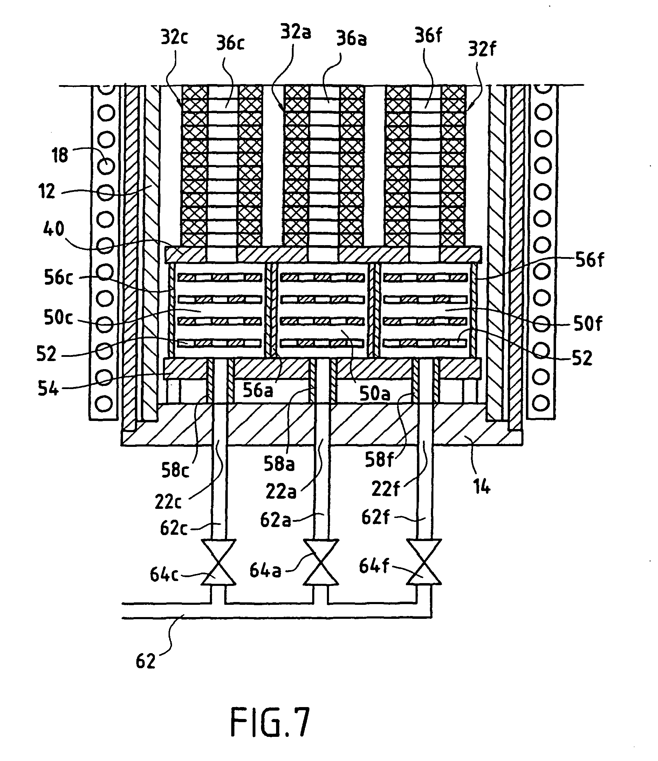

La figure 7 illustre un autre mode de réalisation de l'alimentation d'un four en gaz réactif dans le cas d'un chargement formé de plusieurs piles annulaires. Ce mode de réalisation se distingue de celui de la figure 5 en ce que les piles sont alimentées individuellement en gaz réactif.

Ainsi, une pluralité de passages sont formés dans le fond 14 du four, sensiblement alignés avec les volumes internes des piles. Sur la figure 7, seuls trois passages 22a, 22c et 22f sont visibles, alignés avec les volumes internes 36a, 36c, 36f des piles 32a, 32c et 32f. Des conduites d'alimentation individuelles en gaz réactif telles que 62a, 62c, 62f se raccordent aux passages formés dans le fond du four.

Les piles supportées par le plateau 40 surmontent des zones de chauffage individuelles telles que 50a, 50c, 50f. Les zones de chauffage sont délimitées chacune par une paroi verticale cylindrique telle que 56a, 56c, 56f, un fond 54 commun et le plateau 40. Des conduites telles que 58a, 58c, 58f relient les ouvertures formées dans le fond du four aux différentes zones de chauffage, à travers des orifices formés dans le fond 54. Chaque zone de chauffage comprend une pluralité de plateaux perforés 52 disposés les uns au-dessus des autres.

Des vannes telles que 64a, 64c, 64f sont montées sur les conduites d'alimentation individuelles.

Dans l'exemple illustré, le gaz réactif provenant du dispositif de préchauffage (non montré sur la figure 7) circule dans une conduite commune 62 à laquelle les conduites individuelles telles que 62a, 62c, 62f sont raccordées. Les piles sont alors alimentées en gaz réactif préchauffé à la même température.

En variante, et pour tenir compte d'éventuelles différences de températures dans les zones de chauffage et au bas des piles, selon l'emplacement de celles-ci dans le four, les conduites individuelles telles que 62a, 62c, 62f peuvent être reliées à des dispositifs de préchauffage respectifs. De la sorte, la température de préchauffage du gaz réactif peut être ajustée individuellement en fonction de la position dans le four de la pile de substrats à laquelle le gaz réactif est destiné.

On notera enfin que le domaine d'application de l'invention n'est en aucune manière limité à la réalisation de disques de frein en composite C/C mais s'étend aussi à la réalisation d'autres pièces en composite C/C, par exemple des divergents de tuyères de moteurs fusée, comme montré notamment dans le brevet US 5 904 957 déjà cité. Plus généralement, l'invention peut être mise en oeuvre pour la réalisation de pièces en tout type de matériau composite thermostructural, c'est-à-dire non seulement des composites C/C mais aussi des CMC. Dans ce dernier cas, la composition du gaz réactif est choisie en fonction de la nature particulière de la matrice céramique. Des précurseurs gazeux de matrices céramiques sont bien connus, par exemple le méthyltrichlorosilane (MTS) et le gaz hydrogène (H₂) pour former une matrice en carbure de silicium. On pourra se référer au brevet FR 2 401 888 qui décrit des procédés de formation de différentes matrices céramiques.

## Revendications

1. Procédé de densification de substrats poreux par une matrice obtenue par infiltration chimique en phase gazeuse en utilisant un gaz réactif contenant au moins un précurseur gazeux du matériau de la matrice, le procédé comprenant :
- le chargement de substrats à densifier dans une zone de chargement d'un four,
- le chauffage des substrats dans le four afin de les porter à une température à laquelle le matériau de matrice souhaité est formé à partir du ou des précurseurs gazeux contenus dans le gaz réactif,
- l'admission du gaz réactif à une extrémité du four, et
- le chauffage du gaz réactif, après entrée dans le four, par passage dans une zone de chauffage de gaz située en amont de la zone de chargement, dans le sens d'écoulement du gaz réactif dans le four,
et étant **caractérisé en ce que** :
- le gaz réactif est préchauffé avant entrée dans le four pour être amené, à son entrée dans le four, à une température intermédiaire entre la température ambiante et la température de chauffage des substrats.

2. Procédé selon la revendication 1, **caractérisé en ce que** les substrats sont portés à une température supérieure à 900°C et le gaz réactif est préchauffé, avant entrée dans le four pour être amené, à son entrée dans le four, à une température au moins égale à environ 200°C.

3. Procédé selon la revendication 2, **caractérisé en ce que** le gaz réactif est préchauffé, avant entrée dans le four, à une température au plus égale à 800°C.

4. Procédé selon la revendication 2, **caractérisé en ce que** le gaz réactif est préchauffé, avant entrée dans le four, à une température au plus égale à 600°C.

5. Procédé selon l'une quelconque des revendications 1 à 4, **caractérisé en ce que** le gaz réactif est préchauffé à l'extérieur du four par passage dans un échangeur de chaleur.

6. Procédé selon l'une quelconque des revendications 1 à 5, **caractérisé en ce que** le gaz réactif est préchauffé à l'extérieur du four sous une pression sensiblement égale à celle régnant dans le four.

7. Procédé selon l'une quelconque des revendications 1 à 5, **caractérisé en ce que** le gaz réactif est préchauffé à l'extérieur du four sous une pression supérieure à celle régnant dans le four et est détendu avant son entrée dans le four.

8. Procédé selon l'une quelconque des revendications 1 à 7 pour la densification de substrats annulaires poreux pour disques de frein en matériau composite carbone/carbone.

9. Procédé selon la revendication 8, **caractérisé en ce que** les substrats sont chargés dans le four en une ou plusieurs piles annulaires et le gaz réactif issu de la zone de chauffage de gaz est canalisé vers l'un des deux volumes constitués par le ou les volumes internes de la ou des piles annulaires et par le volume de la zone de chargement extérieur à la ou aux piles annulaires, et un gaz effluent est recueilli dans l'autre des deux volumes pour être évacués hors du four.

10. Procédé selon la revendication 9, **caractérisé en ce que** les substrats sont empilés en ménageant entre eux des passages de fuite faisant communiquer lesdits deux volumes entre eux.

11. Procédé selon la revendication 9, **caractérisé en ce que** les substrats sont empilés sans ménager entre eux de passages de fuite, de sorte que le passage du gaz réactif de l'un à l'autre desdits deux volumes se fait uniquement à travers la porosité des substrats.

12. Procédé selon l'une quelconque des revendications 9 à 11, **caractérisé en ce que** les piles annulaires sont alimentées individuellement en gaz réactif à travers des passages respectifs d'une paroi du four.

13. Procédé selon la revendication 12, **caractérisé en ce que** la température de préchauffage du gaz réactif alimentant les piles de substrats est ajustée individuellement pour chaque pile.

14. Installation de densification de substrats poreux par infiltration chimique en phase vapeur, comprenant un four (10), une zone (30) de chargement de substrats dans le four, des moyens (12) de chauffage de substrats dans la zone de chargement, au moins une entrée (22 ; 22a, 22c, 22f) de gaz réactif dans le four, et au moins une zone (50 ; 50a, 50c, 50f) de chauffage de gaz située dans le four entre l'entrée du gaz réactif et la zone de chargement,
**caractérisée en ce que** l'installation comprend en outre au moins un dispositif (60 ; 80) de préchauffage de gaz situé à l'extérieur du four (10) et relié à au moins une entrée de gaz réactif dans le four, de manière à préchauffer le gaz réactif avant son entrée dans le four.

15. Installation selon la revendication 14, **caractérisée en ce que** le dispositif de préchauffage comporte un tube à passage de courant (66) inséré sur un conduit d'amenée du gaz réactif à l'entrée du gaz réactif dans le four.

16. Installation selon la revendication 14, **caractérisée en ce que** le dispositif de préchauffage comporte une chaudière à gaz (80) parcourue par au moins un conduit pour la circulation du gaz réactif à préchauffer.

17. Installation selon la revendication 16, **caractérisée en ce que** la chaudière est reliée à une sortie (24) de gaz effluent hors du four afin d'utiliser au moins une partie du gaz effluent comme gaz de combustion pour la chaudière.

18. Installation selon la revendication 14, **caractérisée en ce que** le dispositif de préchauffage comporte un four à chauffage électrique parcouru par au moins un tube pour la circulation du gaz réactif à préchauffer.

19. Installation selon l'une quelconque des revendications 14 à 18, **caractérisée en ce qu'**elle comporte un détendeur entre le dispositif de préchauffage et l'entrée de gaz réactif dans le four.

20. Installation selon l'une quelconque des revendications 14 à 19, **caractérisée en ce que** le dispositif de préchauffage comprend des moyens de régulation de température.

21. Installation selon l'une quelconque des revendications 14 à 20 pour la densification de substrats annulaires disposés en une pluralité de piles, **caractérisée en ce qu'**elle comprend une pluralité de zones de chauffage (50a, 50c, 50f) située chacune entre une entrée respective (22a, 22c, 22f) de gaz réactif dans le four et un emplacement respectif d'une pile annulaire dans la zone de chargement.

22. Installation selon la revendication 21, **caractérisée en ce qu'**elle comprend une pluralité de conduites d'alimentation individuelles en gaz réactif préchauffé (62a, 62c, 62f) reliées aux entrées de gaz réactif dans le four.

23. Installation selon la revendication 22, **caractérisée en ce que** les conduites d'alimentation individuelles (62a, 62c, 62f) sont reliées à un dispositif de préchauffage par une conduite commune.

24. Installation selon la revendication 22, **caractérisée en ce que** les conduites d'alimentation individuelles sont reliées à des dispositifs respectifs de préchauffage de gaz réactif.

## Claims

1. A method of densifying porous substrates with a matrix obtained by chemical vapor infiltration using a reactive gas containing at least one gaseous precursor of the matrix material, the method comprising:
- loading substrates for densification in a loading zone of an oven;
- heating the substrates in the oven so as to raise them to a temperature at which the desired matrix material is formed from at least one precursor gas contained in the reactive gas;
- admitting the reactive gas to one end of the oven; and
- heating the reactive gas after it has entered into the oven by passing it through a gas heating zone situated upstream from the loading zone in the flow direction of the reactive gas in the oven;
the method being **characterised in that**:
- the reactive gas is preheated prior to entering into the oven so that on entering into the oven it is brought to an intermediate temperature between ambient temperature and the temperature to which the substrates are heated.

2. A method according to claim 1, **characterised in that** the substrates are raised to a temperature greater than 900°C and the reactive gas is preheated, prior to entering the oven, so as to be raised to a temperature of not less than about 200°C on entering into the oven.

3. A method according to claim 2, **characterised in that** the reactive gas is preheated to a temperature no greater than 800°C prior to entering the oven.

4. A method according to claim 2, **characterised in that** the reactive gas is preheated to a temperature no greater than 600°C prior to entering the oven.

5. A method according to any one of claims 1 to 4, **characterised in that** the reactive gas is preheated outside the oven by passing it through a heat exchanger.

6. A method according to any one of claims 1 to 5, **characterised in that** the reactive gas is preheated outside the oven at a pressure which is substantially equal to the pressure inside the oven.

7. A method according to any one of claims 1 to 5, **characterised in that** the reactive gas is preheated outside the oven at a pressure which is higher than the pressure in the oven, and is expanded prior to entering into the oven.

8. A method according to any one of claims 1 to 7, for densifying porous annular substrates for brake disks made of carbon/carbon composite material.

9. A method according to claim 8, **characterised in that** the substrates are loaded into the oven in one or more annular stacks and the reactive gas from the gas heating zone is channelled into one of the two volumes constituted by the volume(s) inside the annular stack(s) and by the volume of the loading zone outside the annular stack(s), and an effluent gas is taken from the other one of the two volumes to be evacuated from the oven.

10. A method according to claim 9, **characterised in that** the substrates are stacked so as to leave leakage passages between them, putting said two volumes into communication with each other.

11. A method according to claim 9, **characterised in that** the substrates are stacked without leaving leakage passages between them, so that the reactive gas can pass from one of said two volumes to the other solely by passing through the pores of the substrates.

12. A method according to any one of claims 9 to 11, **characterised in that** the annular stacks are individually fed with reactive gas via respective passages through a wall of the oven.

13. A method according to claim 12, **characterised in that** the preheating temperature of the reactive gas feeding the stacks of substrates is adjusted individually for each stack.

14. An installation for densifying porous substrates by chemical vapour infiltration, the installation comprising an oven (10), a zone (30) for loading substrates into the oven, means (12) for heating substrates in the loading zone, at least one inlet (22; 22a, 22c, 22f) for admitting reactive gas into the oven, and at least one gas heating zone (50; 50a; 50c; 50f) situated in the oven between the reactive gas inlet and the loading zone;
the installation being **characterised in that** it further comprises at least one gas preheater device (60; 80) situated outside the oven (10) and connected to at least one reactive gas inlet to the oven, so as to preheat the reactive gas before it enters the oven.

15. An installation according to claim 14, **characterised in that** the preheater device comprises an electrical heater tube (66) inserted in a duct for feeding reactive gas to the reactive gas inlet of the oven.

16. An installation according to claim 14, **characterised in that** the preheater device comprises a gas boiler (80) having at least one duct passing therethrough to convey a flow of reactive gas to be preheated.

17. An installation according to claim 16, **characterised in that** the boiler is connected to an outlet (24) for removing effluent gas from the oven so as to use at least a fraction of the effluent gas as fuel gas for the boiler.

18. An installation according to claim 14, **characterised in that** the preheater device comprises an electrically heated oven having at least one tube passing therethrough to carry a flow of reactive gas to be preheated.

19. An installation according to any one of claims 14 to 18, **characterised in that** it includes an expander between the preheater device and the inlet for reactive gas into the oven.

20. An installation according to any one of claims 14 to 19, **characterised in that** the preheater device includes temperature regulator means.

21. An installation according to any one of claims 14 to 20, for densifying annular substrates placed in a plurality of stacks, the installation being **characterised in that** it has a plurality of heating zones (50a, 50c, 50f) each situated between a respective inlet (22a, 22c, 22f) for reactive gas into the oven and a respective location for an annular stack in the loading zone.

22. An installation according to claim 21, **characterised in that** it has a plurality of individual feed pipes (62a, 62c, 62f) for preheated reactive gas connected to the reactive gas inlets into the oven.

23. An installation according to claim 22, **characterised in that** the individual feed pipes (62a, 62c, 62f) are connected to a preheater device via a common pipe.

24. An installation according to claim 22, **characterised in that** the individual feed pipes are connected to respective devices for preheating reactive gas.

## Patentansprüche

1. Verfahren zur Verdichtung von porösen Substraten durch eine Matrix, erhalten durch chemische Infiltration in Gasphase und der Verwendung eines reaktiven Gases, das wenigstens einen gasförmigen Vorläufer des Matrixmaterials enthält, wobei das Verfahren umfaßt:
- die Beladung der zu verdichtenden Substrate in eine Ladezone eines Ofens,
- das Heizen der Substrate in dem Ofen, um sie auf eine Temperatur zu bringen, bei der das gewünschte Matrixmaterial aus dem oder den gasförmigen Vorläufern gebildet wird, die in dem reaktiven Gas enthalten sind,
- Einlaß des reaktiven Gases an einem Ende des Ofens, und
- Heizen des reaktiven Gases nach Eintritt in den Ofen durch Durchgang in einer Gasheizzone, die in Fließrichtung des reaktiven Gases stromaufwärts der Ladezone in dem Ofen angeordnet ist,
und **dadurch gekennzeichnet, daß**:
- das reaktive Gas vor Eintritt in den Ofen vorgeheizt wird, um bei seinem Eintritt in den Ofen auf eine Zwischentemperatur zwischen der Umgebungstemperatur und der Heiztemperatur der Substrate gebracht zu sein.

2. Verfahren nach Anspruch 1, **dadurch gekennzeichnet, daß** die Substrate auf eine Temperatur über 900°C gebracht werden und das reaktive Gas vorgewärmt wird, bevor es in den Ofen eintritt, um bei seinem Eintritt in den Ofen auf eine Temperatur von wenigstens gleich etwa 200°C gebracht zu sein.

3. Verfahren nach Anspruch 2, **dadurch gekennzeichnet, daß** das reaktive Gas vorgewärmt wird vor Eintritt in den Ofen auf eine Temperatur höchstens gleich 800°C.

4. Verfahren nach Anspruch 2, **dadurch gekennzeichnet, daß** das reaktive Gas vorgewärmt wird vor Eintritt in den Ofen auf eine Temperatur höchstens gleich 600°C.

5. Verfahren nach der Ansprüche bis 4, **dadurch gekennzeichnet, daß** das reaktive Gas außerhalb des Ofens durch Durchgang durch einen Wärmetauscher vorgewärmt wird,

6. Verfahren nach einem der Ansprüche 1 bis 5, **dadurch gekennzeichnet, daß** das reaktive Gas außerhalb des Ofens unter einem Druck im wesentlichen gleich jenem der in dem Ofen herrscht, vorgewärmt wird.

7. Verfahren nach einem der Ansprüche 1 bis 5, **dadurch gekennzeichnet, daß** das reaktive Gas außerhalb des Ofens unter einem Druck über jenem, der in dem Ofen herrscht, vorgewärmt und vor seinem Eintritt in den Ofen entspannt wird,.

8. Verfahren nach einem der Ansprüche 1 bis 7 zur Verdichtung von ringförmigen porösen Substraten für Bremsscheiben aus Karbon/Karbon-Kompositmaterial.

9. Verfahren nach Anspruch 8, **dadurch gekennzeichnet, daß** die Substrate in den Ofen in einem oder mehreren ringförmigen Stapeln geladen werden und das reaktive Gas aus der Gasheizzone zu einem der beiden Volumina kanalisiert wird, die durch das oder die Innenvolumina der ringförmigen Stapel gebildet werden und durch das Volumen der Ladezone außerhalb des oder der ringförmigen Stapel und ein Gasstrom in dem anderen der beiden Volumina gesammelt wird, um aus dem Ofen heraus abgezogen zu werden.

10. Verfahren nach Anspruch 9, **dadurch gekennzeichnet, daß** die Substrate gestapelt sind, indem man zwischen ihnen Verflüchtigungsdurchgänge einrichtet, die die beiden Volumina untereinander in Verbindung treten lassen.

11. Verfahren nach Anspruch 9, **dadurch gekennzeichnet, daß** die Substrate ohne unter ihnen Verflüchtigungsdurchgänge einzurichten derart gestapelt werden, daß der Durchgang des reaktiven Gases von einem zum anderen der beiden Volumina lediglich durch die Porosität der Substrate geschieht.

12. Verfahren nach einem der Ansprüche 9 bis 11, **dadurch gekennzeichnet, daß** die ringförmigen Stapel mit reaktivem Gas der jeweiligen Durchgänge einer Wand des Ofens gespeist werden.

13. Verfahren nach Anspruch 12, **dadurch gekennzeichnet, daß** die Heiztemperatur des reaktiven Gases, das die Substratstapel speist, individuell für jeden Stapel eingestellt wird.

14. Anlage zur Verdichtung von porösen Substraten durch chemische Infiltration in Dampfphase, umfassend einen Ofen (10), eine Ladezone (30) für Substrate in dem Ofen, Heizmittel (12) für Substrate in der Ladezone, wenigstens einen Eingang (22; 22a, 22c, 22f) von reaktivem Gas in dem Ofen und wenigstens eine Zone (50; 50a, 50c, 50f) zum Heizen des Gases, angeordnet in dem Ofen zwischen dem Eingang des reaktiven Gases und der Ladezone, **dadurch gekennzeichnet, daß** die Anlage außerdem wenigstens eine Vorrichtung (60; 80) zum Vorheizen von Gas umfaßt, angeordnet außerhalb des Ofens (10) und verbunden mit wenigstens einem Eingang von reaktivem Gas in dem Ofen derart, daß das reaktive Gas vor seinem Eintritt in den Ofen vorgewärmt wird.

15. Anlage nach Anspruch 14, **dadurch gekennzeichnet, daß** die Vorrichtung zum Vorwärmen wenigstens ein Rohr mit Strömungsdurchgang (66) umfaßt, das in der Leitung zur Zufuhr des reaktiven Gases am Eintritt des reaktiven Gases in den Ofen angeordnet ist.

16. Anlage nach Anspruch 14, **dadurch gekennzeichnet, daß** die Varwärmvorrichtung eine Gasheizung (80) umfaßt, die von wenigstens einer Leitung zur Zirkulation des reaktiven vorzuwärmenden Gases durchlaufen wird.

17. Anlage nach Anspruch 16, **dadurch gekennzeichnet, daß** die Heizung mit einem Austritt (24) des Gasstroms aus dem Ofen heraus verbunden ist, um wenigstens einen Teil des Gasstroms als Brenngas für die Heizung zu verwenden.

18. Anlage nach Anspruch 14, **dadurch gekennzeichnet, daß** die Vorwärmvorrichtung einen Ofen mit elektrischer Heizung umfaßt, der durch wenigstens ein Rohr zur Zirkulation des reaktiven vorzuwärmenden Gases durchlaufen wird.

19. Anlage nach einem der Ansprüche 14 bis 18, **dadurch gekennzeichnet, daß** sie eine Entspannungsvorrichtung zwischen der Heizvorrichtung und dem Eintritt eines reaktiven Gases in den Ofen umfaßt.

20. Anlage nach einem der Ansprüche 14 bis 19, **dadurch gekennzeichnet, daß** die Vorwärmvorrichtung Mittel zur Temperaturregelung umfaßt.

21. Anlage nach einem der Ansprüche 14 bis 20 zur Verdichtung von ringförmigen Substraten, die in einer Vielzahl von Stapeln angeordnet sind, **dadurch gekennzeichnet, daß** sie eine Mehrzahl von Heizzonen (50a, 50c, 50f) umfaßt, die jede zwischen einem jeweiligen Eintritt (22a, 22c, 22f) von reaktivem Gas in den Ofen und einem jeweiligen Ort eines ringförmigen Stapels in der Ladezone angeordnet sind.

22. Anlage nach Anspruch 21, **dadurch gekennzeichnet, daß** sie eine Vielzahl von individuellen Leitungen zur Versorgung mit reaktivem vorgewärmten Gas (62a, 62c, 62f) umfaßt, die mit Eingängen von reaktivem Gas in den Ofen verbunden sind.

23. Anlage nach Anspruch 22, **dadurch gekennzeichnet, daß** die individuellen Versorgungsleitungen (62a, 62c, 62f) mit einer Vorwärmvorrichtung durch eine gemeinsame Leitung verbunden sind.

24. Anlage nach Anspruch 22, **dadurch gekennzeichnet, daß** die individuellen Versorgungsleitungen mit jeweiligen Vorrichtungen zum Vorheizen von reaktivem Gas verbunden sind.
